# EUROPEAN PATENT APPLICATION

(11) **EP 2 940 748 A1**
(43) Date of publication of application: **04.11.2015**
(21) Application number: 13867793.5
(22) Date of filing: 27.12.2013
(51) Int. Cl.: H01L 33/60, C08K 3/22, C08K 3/30, C08K 3/38, C08L 83/04

(54) **COATING LIQUID, AND LED DEVICE PROVIDED WITH REFLECTIVE LAYER THAT IS FORMED OF CURED PRODUCT OF SAID COATING LIQUID**

(30) Priority: 27.12.2012 JP 2012285347; 24.07.2013 JP 2013153526
(71) Applicant: Konica Minolta, Inc., Tokyo 100-7015 (JP)
(72) Inventor: KOJIMA, Takeshi, Chiyoda-ku, Tokyo 100-7015 (JP)
(74) Representative: Henkel, Breuer & Partner
(86) International application number: PCT/JP2013/007664
(87) International publication number: WO 2014/103326

(57) **Abstract**

The present invention addresses the problem of providing: an LED device which is not susceptible to deterioration in a reflective layer for reflecting light emitted from all LED element and the like, and which is capable of efficiently extracting light for a long period of time; and a method for manufacturing the LED device. In order to solve the above-mentioned problem, the present invention provides a coating liquid which contains a white pigment, a silane compound and a solvent, and which satisfies the conditions expressed by formula (1) and formula (2), where R2 (mol%) is the ratio of a bifunctional silane compound in the total amount of the silane compound, R3 (mol%) is the ratio of a trifunctional silane compound in the total amount of the silane compound, and R4 (mol%) is the ratio of a tetrafunctional silane compound in the total amount of the silane compound, 0 ≤ R2 < 20 (1) 0 ≤ R4/R3 ≤ 3 (2)

## Description

### Technical Field

The present invention relates to a coating liquid and an LED device including a reflective layer made of a product obtained by curing the coating liquid.

### Background Art

Recent years have seen wide use of light emitting diode (LED) devices that include a gallium nitride (GaN) -based blue LED chip and a fluorescent material such as a YAG fluorescent material disposed in the vicinity thereof so that blue light emitted from the blue LED chip and yellow light emitted from the fluorescent material receiving the blue light are mixed to form white light. Also developed have been LED devices that include a blue LED chip and different fluorescent materials disposed in the vicinity thereof so that blue light emitted from the blue LED chip and red light and green light emitted from the fluorescent materials receiving the blue light are mixed to form white light.

White LED devices have a variety of uses, such as alternatives needed to replace fluorescent and incandescent lamps. Such illumination devices include a combination of two or more white LED devices, in which how to increase the efficiency of light extraction from each white LED device is important in order to reduce costs and achieve long life.

Some conventional LED devices have a problem in that substrates and other materials on which LED elements are disposed can easily absorb light emitted by LED elements and fluorescent light emitted by fluorescent materials to make light extraction performance insufficient. In general LED devices, therefore, a reflector with high light reflectance is arranged around an LED element. Such a reflector is generally a metal plating film or the like.

Unfortunately, the metal plating film reflector cannot be formed over the surface of the substrate because electrical conduction needs to be prevented. Thus, there is a problem in that light is absorbed by the substrate at the region where no reflector is formed.

On the other hand, there are also proposed a reflector including a metal plating film covered with a resin layer (Patent Literature 1) and a reflector including a metal plating film covered with a white resin layer (Patent Literature 2).

### Citation List

### Patent Literatures

Patent Literature 1: JP 2005-136379 A
Patent Literature 2: JP 2011-23621 A

### Summary of Invention

### Technical Problem

However, the reflector made of resin or the metal plating film reflector with its surface covered with resin as in the technique of Patent Literature 1 has a problem in that the resin is degraded by heat or light, so that the light reflecting properties of the reflective layer degrade over time and electrical conduction can occur. In particular, the resin can easily degrade in applications requiring a large quantity of light, such as headlights for vehicles.

As in the technique of Patent Literature 2, a substrate or a metal plating film can be covered with a thermoset resin containing a white pigment. In this case, however, the thermoset resin (such as an epoxy resin), which has an organic main skeleton, is colored at high temperature. This results in a problem in that the reflectance and the light extraction efficiency can decrease.

On the other hand, studies have been conducted to cover a metal plating film or the like with silicone resin with relatively high heat resistance. However, silicone resin is relatively gas-permeable. Therefore, when a silver or silver plating film is covered with silicone resin, a small amount of hydrogen sulfide in the air can discolor the silver and reduce the reflectance easily. Therefore, the reduction in light extraction efficiency cannot be suppressed sufficiently.

The present invention has been made in view of these circumstances. It is therefore an object of the present invention to provide a reflective layer that is suitable for use in LED devices, less degradable over a long period of time, and capable of efficiently reflecting light, and to provide a coating liquid for forming such a reflective layer.

### Solution to Problem

The present invention is directed to the following.
1. A coating liquid including a white pigment, a silane compound or compounds, and a solvent,
   the coating liquid satisfying both of the following conditions: 0 ≤ R2 < 20 (formula 1) ; and 0 ≤ R4/R3 ≤ 3 (formula 2), wherein R2 is the content (% by mole) of a bifunctional silane compound in the total amount of the silane compound or compounds, R3 is the content (% by mole) of a trifunctional silane compound in the total amount of the silane compound or compounds, and R4 is the content (% by mole) of a tetrafunctional silane compound in the total amount of the silane compound or compounds.
2. The coating liquid according to the above 1, wherein at least one selected from the group consisting of the bifunctional silane compound, the trifunctional silane compound, and the tetrafunctional silane compound is already polymerized.
3. The coating liquid according to the above 1 or 2, further including, apart from the white pigment, at least one selected from the group consisting of metal oxide fine particles with an average particle size of 5 nm to less than 100 nm, inorganic particles with an average particle size of 100 nm to 100 µm, and clay mineral particles.
4. The coating liquid according to the above 3, wherein the clay mineral particles are made of at least one selected from the group consisting of a layered silicate mineral, imogolite, and allophane.
5. The coating liquid according to any one of the above 1 to 4, further including a silane coupling agent.
6. The coating liquid according to any one of the above 1 to 5, wherein the solvent includes at least one of a monohydric alcohol and a dihydric or polyhydric alcohol.
7. The coating liquid according to any one of the above 1 to 6, wherein the white pigment is at least one selected from the group consisting of titanium oxide, aluminum oxide, barium sulfate, zinc oxide, and boron nitride.
8. The coating liquid according to any one of the above 1 to 7, which has a viscosity of more than 5 mPa · s to 500 mPa·s.
9. The coating liquid according to any one of the above 1 to 8, which contains the white pigment in such a concentration that a solid obtained by heating and curing the coating liquid contains 60% by weight to 95% by weight of the white pigment.
10. An LED device including:
   a substrate;
   an LED element disposed on the substrate;
   a reflective layer disposed at least around the LED element on the substrate; and
   a wavelength conversion layer disposed over the LED element and the reflective layer, wherein
   the reflective layer is a product obtained by heating and curing a coating liquid that includes a white pigment, a silane compound or compounds, and a solvent and satisfies both of the following conditions: 0 ≤ R2 < 20 (formula 1); and 0 ≤ R4/R3 ≤ 3 (formula 2), wherein R2 is the content (% by mole) of a bifunctional silane compound in the total amount of the silane compound or compounds, R3 is the content (% by mole) of a trifunctional silane compound in the total amount of the silane compound or compounds, and R4 is the content (% by mole) of a tetrafunctional silane compound in the total amount of the silane compound or compounds.
11. The LED device according to the above 10, wherein the reflective layer is disposed on an area of the substrate, other than an area where the LED element is disposed.
12. The LED device according to the above 10, wherein the reflective layer is formed between the substrate and the LED element.

### Advantageous Effects of Invention

The use of the coating liquid of the present invention makes it possible to provide a reflective layer being for use in LED devices and capable of efficiently reflecting light and thus to provide an LED device that allows efficient light extraction over a long period of time.

### Brief Description of Drawings

Fig. 1 is a top view of an LED device according to an embodiment.
Fig. 2 is a cross-sectional view of an LED device according to an embodiment.
Fig. 3 is a cross-sectional view of an LED device according to a modified embodiment.
Fig. 4 is a cross-sectional view of an LED device according to a modified embodiment.
Fig. 5 is a cross-sectional view of an LED device according to a modified embodiment.
Fig. 6 is a chart showing an example of a solid-state Si-NMR spectrum.

### Description of Embodiments

Hereinafter, the present invention will be described with reference to embodiments. It will be understood that the embodiments described below are not intended to limit the present invention. In the drawings, elements having the same or similar functions are represented by the same or similar reference signs so that they do not need to be described in detail again. It should be noted that the drawings are schematic. Therefore, specific dimensions and the like should be determined in consideration of the following description.

### [Coating liquid]

A coating liquid according to an embodiment includes (A) a white pigment, (B) a silane compound or compounds, and (C) a solvent. The coating liquid may further contain metal oxide fine particles with an average particle size of 5 nm to less than 100 nm, inorganic particles with an average particle size of 100 nm to 100 µm, clay mineral particles, a silane coupling agent, or the like.

The coating liquid satisfies both of the following conditions: 0 ≤ R2 < 20 (formula 1) ; and 0 ≤ R4/R3 ≤ 3 (formula 2), wherein R2, R3, and R4 are the contents (% by mole) of bifunctional, trifunctional, and tetrafunctional silane compounds, respectively, in the total amount of the silane compound or compounds (B).

If R2 is 20 or more against formula 1, the layer obtained by curing the coating liquid can have lower adhesion to the substrate. In that case, the layer obtained by curing the coating liquid may also have lower gas barrier properties and lower sulfuration resistance. Therefore, R2 is preferably in the above range, more preferably 0 to less than 15 (0 ≤ R2 < 15), even more preferably 0 to less than 10 (0 ≤ R2 < 10).

If the R4/R3 value is more than 3 against formula 2, cracking may occur during film formation. Therefore, the R4/R3 value is preferably 3 or less, more preferably 0 to less than 2 (0 ≤ R4/R3 < 2), even more preferably 0 to less than 1 (0 ≤ R4/R3 < 1).

The contents of bifunctional, trifunctional, and tetrafunctional silane compounds in the silane compounds in the coating liquid can be determined from the solid-state Si-NMR spectrum of a sample obtained by drying and solidifying the coating liquid at 150°C.

Hereinafter, the solid-state Si-nuclear magnetic resonance (hereinafter referred to as NMR) spectrum will be described.

A polymer of a tetrafunctional silane compound, which is represented by the rational formula: SiO₂ · nH₂O, has a structure in which the oxygen (O) atom bonded to the silicon (S) atom is located at each apex of the silicon tetrahedron and such oxygen (O) atoms are further bonded to silicon (S) atoms to form a network.

Schematic diagram (A) below shows the Si-O network structure, not taking into account the tetrahedron structure. Schematic diagram (B) below shows a structure in which some of the oxygen (0) atoms in the Si-O network structure are replaced by other members (-H in this case). Silicon atoms derived from a tetrafunctional silane compound include an atom (Q⁴) bonded to four -OSi groups as shown in schematic diagram (A) and an atom (Q³) bonded to three -OSi groups as shown in schematic diagram (B). In a solid-state Si-NMR spectrum, peaks based on silicon atoms derived from a tetrafunctional silane compound are generically called Q sites, and peaks derived from these atoms are called a Q⁴ peak, a Q³ peak, ..., respectively. In the description, Q⁰ to Q⁴ peaks derived from Q sites are called a Qⁿ peak group. The Qⁿ peak group of a silica film containing no organic substituents is generally observed as continuous multiple peaks in the chemical shift range of -80 to -130 ppm.

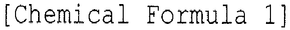

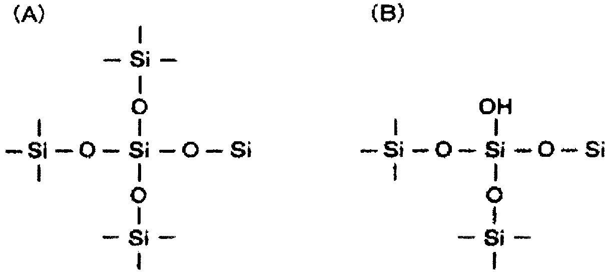

On the other hand, silicon atoms each bonded to tree oxygen atoms and one other atom (generally carbon) (namely, silicon atoms derived from a trifunctional silane compound) are generically called T sites. As in the case of Q sites, peaks derived from T sites are observed as T⁰ to T³ peaks, respectively. In the description, peaks derived from T sites are called a Tⁿ peak group. The Tⁿ peak group is generally observed as continuous multiple peaks in a region on the higher magnetic field side (generally in the chemical shift range of -80 to -40 ppm) than that of the Qⁿ peak group.

Silicon atoms each bonded to two oxygen atoms and two other atoms (generally carbon) (namely, silicon atoms derived from a bifunctional silane compound) are generically called D sites. Peaks derived from D sites are also observed as D⁰ to Dⁿ peaks (Dⁿ peak group), respectively, like the peak group derived from Q or T sites. Peaks derived from D sites are observed as multiple peaks in a region on the further higher magnetic field side (generally in the chemical shift range of -3 to -40 ppm) than that of the Qⁿ or Tⁿ peak group.

Similarly, silicon atoms each bonded to one oxygen atom and three other atoms (generally carbon atoms) are generically called M sites, which are observed multiple peaks in a region on the highest magnetic field side (generally in the chemical shift range of 0 to -3 ppm).

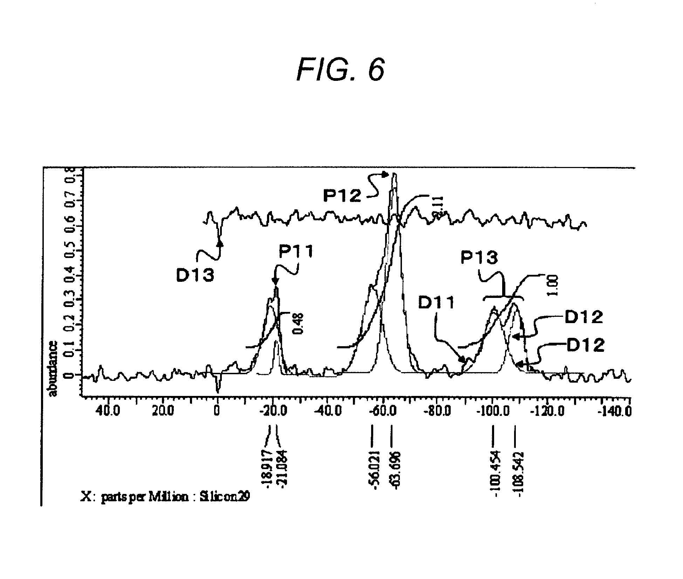

Now reference will be made to Fig. 6. Fig. 6 is an example of the solid-state Si-NMR spectrum of a polymer of a silane compound. In Fig. 6, the horizontal axis represents chemical shift and the vertical axis represents the "relative intensity" depending on the content of each compound structure.

In Fig. 6, D11 indicates the measured data. D12 indicates the data modeled by a Gaussian function. D13 indicates the difference spectrum. Peak P11 indicates the Dⁿ peak group, and the peak top of the Dⁿ peak group is observed at a chemical shift of about -20.0 ppm. Peak P12 indicates the Tⁿ peak group, and the peak top of the Tⁿ peak group is observed at a chemical shift of about -60.0 ppm. Peak P13 indicates the Qⁿ peak group, and the peak top of the Qⁿ peak group is observed at a chemical shift of about -100.0 to -110 ppm. Therefore, Fig. 6 shows that the polymer contains silicon atoms derived from bifunctional, trifunctional, and tetrafunctional silane compounds.

The area ratio of each of the Dⁿ, Tⁿ, and Qⁿ peak groups is equal to the molar ratio of silicon atoms in the environment corresponding to each of the peak groups. Therefore, the ratio of the area of each peak group to the total area of the Qⁿ, Tⁿ, and Dⁿ peak groups is equal to the ratio of the moles of each silane compound (each of tetrafunctional, trifunctional, and bifunctional silane compounds) to the total moles of the silicon atoms in the coating liquid.

The coating liquid of the present invention can form a coating film that resists cracking when cured. The layer obtained by curing the coating liquid has good adhesion to inorganic material layers. The layer also has a high level of light reflecting properties and heat reflecting properties. The coating liquid of the present invention may be used in any applications where it is possible to take advantage of such properties. In particular, the coating liquid of the present invention is suitable for forming reflective layers for LED devices. Hereinafter, the coating liquid for use in forming reflective layers will be described as an example.

Hereinafter, each component will be described in detail.

### (White pigment)

The white pigment in the coating liquid may be of any type as long as it includes highly reflective particles.

The white pigment may be at least one selected from calcium carbonate, magnesium carbonate, barium carbonate, magnesium sulfate, barium sulfate, calcium sulfate, zinc oxide, magnesium oxide, calcium oxide, titanium oxide, aluminum oxide, zirconium oxide, zinc sulfide, aluminum hydroxide, boron nitride, aluminum nitride, potassium titanate, barium titanate, aluminum titanate, strontium titanate, calcium titanate, magnesium titanate, hydroxyapatite, and the like. In particular, the white pigment is preferably one or a mixture of two or more selected from titanium oxide, aluminum oxide, barium sulfate, zinc oxide, and boron nitride.

When the white pigment includes boron nitride, the resulting reflective layer can have high thermal conductivity. This makes it possible to quickly dissipate, from the substrate, heat generated by the light-emitting chip. Therefore, the temperature of the LED device can be kept low, and the life of the device can be prolonged.

The white pigment preferably has an average primary particle size of 100 nm to 20 µm, more preferably more than 100 nm to 10 µm, even more preferably 200 nm to 2.5 µm. The term "average primary particle size" refers to the D50 value measured with a laser diffraction particle size distribution analyzer, which may be, for example, a laser diffraction particle size analyzer manufactured by SHIMADZU CORPORATION, or the like.

The amount of the white pigment in the coating liquid is preferably from 60 to 95% by weight, more preferably from 70 to 90% by weight, based on the total weight of the components other than the solvent in the coating liquid. If the amount of the white pigment is less than 60% by weight, the resulting reflective layer may have insufficient light reflecting properties and fail to increase the light extraction efficiency. On the other hand, if the content of the white pigment is more than 95%, the binder content will be relatively low, so that the strength of the reflective layer may decrease or the white pigment may chip from the reflective layer.

### (Silane compound)

As mentioned above, the silane compound in the coating liquid may be a bifunctional, trifunctional, or tetrafunctional silane compound. The silane compound may be a monomer or a polymer (oligomer) of the monomer. When the silane compound is an oligomer having several to several tens monomer units, formed by polymerization in advance, the coating will be less shrinkable in the process of curing the coating liquid, so that cracking will be less likely to occur.

The total amount of the silane compound or compounds in the coating liquid is preferably from 5 to 40% by weight, more preferably from 10 to 30% by weight, based on the total weight of the components other than the solvent in the coating liquid. If the total amount of the silane compound or compounds is less than 5% by weight, the white pigment may fail to be sufficiently bound by a polymer of the silane compound in the resulting reflective layer, so that a powder of the pigment may easily appear on the surface of the reflective layer. If the total amount of the silane compound or compounds is more than 40% by weight, curing-induced shrinkage and cracking may easily occur in the process of forming the reflective layer.

### Trifunctional silane compound

Examples of the trifunctional silane compound include compounds represented by formula (III) below.

R¹Si(OR²)₃ (III)

In formula (III), the R² groups are each independently an alkyl group or a phenyl group, preferably an alkyl group of 1 to 5 carbon atoms or a phenyl group, and R¹ is a hydrogen atom or an alkyl group.

Examples of the trifunctional silane compound include monohydrosilane compounds such as trimethoxysilane, triethoxysilane, tripropoxysilane, tripentyloxysilane, triphenyloxysilane, dimethoxymonoethoxysilane, diethoxymonomethoxysilane, dipropoxymonomethoxysilane, dipropoxymonoethoxysilane, dipentyloxylmonomethoxysilane, dipentyloxymonoethoxysilane, dipentyloxymonopropoxysilane, diphenyloxylmonomethoxysilane, diphenyloxymonoethoxysilane, diphenyloxymonopropoxysilane, methoxyethoxypropoxysilane, monopropoxydimethoxysilane, monopropoxydiethoxysilane, monobutoxydimethoxysilane, monopentyloxydiethoxysilane, and monophenyloxydiethoxysilane; monomethylsilane compounds such as methyltrimethoxysilane, methyltriethoxysilane, methyltripropoxysilane, methyltripentyloxysilane, methylmonomethoxydiethoxysilane, methylmonomethoxydipropoxysilane, methylmonomethoxydipentyloxysilane, methylmonomethoxydiphenyloxysilane, methylmethoxyethoxypropoxysilane, and methylmonomethoxymonoethoxymonobutoxysilane; monoethylsilane compounds such as ethyltrimethoxysilane, ethyltripropoxysilane, ethyltripentyloxysilane, ethyltriphenyloxysilane, ethylmonomethoxydiethoxysilane, ethylmonomethoxydipropoxysilane, ethylmonomethoxydipentyloxysilane, ethylmonomethoxydiphenyloxysilane, and ethylmonomethoxymonoethoxymonobutoxysilane; monopropylsilane compounds such as propyltrimethoxysilane, propyltriethoxysilane, propyltripentyloxysilane, propyltriphenyloxysilane, propylmonomethoxydiethoxysilane, propylmonomethoxydipropoxysilane, propylmonomethoxydipentyloxysilane, propylmonomethoxydiphenyloxysilane, propylmethoxyethoxypropoxysilane, and propylmonomethoxymonoethoxymonobutoxysilane; and monobutylsilane compounds such as butyltrimethoxysilane, butyltriethoxysilane, butyltripropoxysilane, butyltripentyloxysilane, butyltriphenyloxysilane, butylmonomethoxydiethoxysilane, butylmonomethoxydipropoxysilane, butylmonomethoxydipentyloxysilane, butylmonomethoxydiphenyloxysilane, butylmethoxyethoxypropoxysilane, and butylmonomethoxymonoethoxymonobutoxysilane.

When R² is a methyl group in the trifunctional silane compound of formula (III), the surface of the resulting reflective layer can have lower hydrophobicity. This makes it possible to easily wet and cover the reflective layer with a composition for forming a wavelength conversion layer in the process of forming the wavelength conversion layer on the reflection layer. Therefore, the adhesion between the reflective layer and the wavelength conversion layer can be increased. Examples of the trifunctional silane compound of formula (III) in which R² is a methyl group include methyltrimethoxysilane and methyltriethoxysilane. Methyltrimethoxysilane is particularly preferred.

### Tetrafunctional silane compound

Examples of the tetrafunctional silane compound include compounds represented by formula (IV) below.

Si(OR³)₄ (IV)

In formula (IV), the R³ groups are each independently an alkyl group or a phenyl group, preferably an alkyl group of 1 to 5 carbon atoms or a phenyl group.

Examples of the tetrafunctional silane compound include alkoxysilanes such as tetramethoxysilane, tetraethoxysilane, tetrapropoxysilane, tetrabutoxysilane, tetrapentyloxysilane, tetraphenyoxysilane, trimethoxymonoethoxysilane, dimethoxydiethoxysilane, triethoxymonomethoxysilane, trimethoxymonopropoxysilane, monomethoxytributoxysilane, monomethoxytripentyloxysilane, monomethoxytriphenyloxysilane, dimethoxydipropoxysilane, tripropoxymonomethoxysilane, trimethoxymonobutoxysilane, dimethoxydibutoxysilane, triethoxymonopropoxysilane, diethoxydipropoxysilane, tributoxymonopropoxysilane, dimethoxymonoethoxymonobutoxysilane, diethoxymonomethoxymonobutoxysilane, diethoxymonopropoxymonobutoxysilane, dipropoxymonomethoxymonoethoxysilane, dipropoxymonomethoxymonobutoxysilane, dipropoxymonoethoxymonobutoxysilane, dibutoxymonomethoxymonoethoxysilane, dibutoxymonoethoxymonopropoxysilane, and monomethoxymonoethoxymonopropoxymonobutoxysilane, or aryloxysilanes. Among them, tetramethoxysilane and tetraethoxysilane are preferred.

### Bifunctional silane compound

Examples of the bifunctional silane compound include compounds represented by formula (II) below.

R⁴₂Si(OR⁵)₂ (II)

In formula (II), the R⁵ groups are each independently an alkyl group or a phenyl group, preferably an alkyl group of 1 to 5 carbon atoms or a phenyl group, and R⁴ is a hydrogen atom or an alkyl group.

Examples of the bifunctional silane compound include dimethoxysilane, diethoxysilane, dipropoxysilane, dipentyloxysilane, diphenyloxysilane, methoxyethoxysilane, methoxypropoxysilane, methoxypentyloxysilane, methoxyphenyloxysilane, ethoxypropoxysilane, ethoxypentyloxysilane, ethoxyphenyloxysilane, methyldimethoxysilane, methylmethoxyethoxysilane, methyldiethoxysilane, methylmethoxypropoxysilane, methylmethoxypentyloxysilane, methylmethoxyphenyloxysilane, ethyldipropoxysilane, ethylmethoxypropoxysilane, ethyldipentyloxysilane, ethyldiphenyloxysilane, propyldimethoxysilane, propylmethoxyethoxysilane, propylethoxypropoxysilane, propyldiethoxysilane, propyldipentyloxysilane, propyldiphenyloxysilane, butyldimethoxysilane, butylmethoxyethoxysilane, butyldiethoxysilane, butylethoxypropoxysilane, butyldipropoxysilane, butylmethyldipentyloxysilane, butylmethyldiphenyloxysilane, dimethyldimethoxysilane, dimethylmethoxyethoxysilane, dimethyldiethoxysilane, dimethyldipentyloxysilane, dimethyldiphenyloxysilane, dimethylethoxypropoxysilane, dimethyldipropoxysilane, diethyldimethoxysilane, diethylmethoxypropoxysilane, diethyldiethoxysilane, diethylethoxypropoxysilane, dipropyldimethoxysilane, dipropyldiethoxysilane, dipropyldipentyloxysilane, dipropyldiphenyloxysilane, dibutyldimethoxysilane, dibutyldiethoxysilane, dibutyldipropoxysilane, dibutylmethoxypentyloxysilane, dibutylmethoxyphenyloxysilane, methylethyldimethoxysilane, methylethyldiethoxysilane, methylethyldipropoxysilane, methylethyldipentyloxysilane, methylethyldiphenyloxysilane, methylpropyldimethoxysilane, methylpropyldiethoxysilane, methylbutyldimethoxysilane, methylbutyldiethoxysilane, methylbutyldipropoxysilane, methylethylethoxypropoxysilane, ethylpropyldimethoxysilane, ethylpropylmethoxyethoxysilane, dipropyldimethoxysilane, dipropylmethoxyethoxysilane, propylbutyldimethoxysilane, propylbutyldiethoxysilane, dibutylmethoxyethoxysilane, dibutylmethoxypropoxysilane, and dibutylethoxypropoxysilane. In particular, dimethoxysilane, diethoxysilane, methyldimethoxysilane, and methyldiethoxysilane are preferred.

### Oligomer

A silane compound oligomer can be obtained by mixing the bifunctional, trifunctional, and tetrafunctional silane compounds in a desired ratio and allowing the mixture to react in the presence of an acid catalyst, water, and a solvent. The molecular weight of the oligomer can be controlled by the reaction time, the temperature, the concentration of water, or the like.

The oligomer preferably has a weight average molecular weight of 500 to 20,000, more preferably 1,000 to 10, 000, even more preferably 1, 500 to 6, 000 as measured by gel permeation chromatography (GPC). If the oligomer has too high a degree of polymerization, the coating liquid may have high viscosity or some components may precipitate from the coating liquid.

Examples of the solvent for use in the preparation of the oligomer include monohydric alcohols such as methanol, ethanol, propanol, and n-butanol; alkyl carboxylates such as methyl-3-methoxypropionate and ethyl-3-ethoxypropionate; polyhydric alcohols such as ethylene glycol, diethylene glycol, propylene glycol, glycerin, trimethylolpropane, and hexanetriol; monoethers of polyhydric alcohols, such as ethylene glycol monomethyl ether, ethylene glycol monoethyl ether, ethylene glycol monopropyl ether, ethylene glycol monobutyl ether, diethylene glycol monomethyl ether, diethylene glycol monoethyl ether, diethylene glycol monopropyl ether, diethylene glycol monobutyl ether, propylene glycol monomethyl ether, propylene glycol monoethyl ether, propylene glycol monopropyl ether, and propylene glycol monobutyl ether, or monoacetates thereof; esters such as methyl acetate, ethyl acetate, and butyl acetate; ketones such as acetone, methyl ethyl ketone, and methyl isoamyl ketone; polyhydric alcohol ethers derived from polyhydric alcohols by alkyletherification of all the hydroxyl groups of the polyhydric alcohols, such as ethylene glycol dimethyl ether, ethylene glycol diethyl ether, ethylene glycol dipropyl ether, ethylene glycol dibutyl ether, propylene glycol dimethyl ether, propylene glycol diethyl ether, diethylene glycol dimethyl ether, diethylene glycol diethyl ether, and diethylene glycol methyl ethyl ether; and the like. Any of these solvents may be added alone or in combination of two or more.

### (Solvent)

The solvent in the coating liquid may be of any type compatible with the silane compound and capable of uniformly dispersing the white pigment and other materials. Preferably, the solvent includes at least one of a monohydric alcohol and a dihydric or polyhydric alcohol. The coating liquid containing a monohydric alcohol is highly wetting and spreadable and easy to apply. On the other hand, the coating liquid containing a polyhydric alcohol tends to have high viscosity, which makes the white pigment less likely to settle.

Examples of the monohydric alcohol include methanol, ethanol, propanol, butanol, and the like. The content of the monohydric alcohol is preferably from 10 to 50% by weight, more preferably from 20 to 40% by weight, based on the total weight of the coating liquid.

The polyhydric alcohol may be any of a diol or a triol. Examples of the polyhydric alcohol include ethylene glycol, propylene glycol, diethylene glycol, glycerin, 1,3-butanediol, 1,4-butanediol, and the like, preferably include ethylene glycol, propylene glycol, 1,3-butanediol, 1,4-butanediol, and the like. The content of the polyhydric alcohol is preferably from 10 to 50% by weight, more preferably from 20 to 40% by weight, based on the total weight of the coating liquid.

The solvent may include water. When the coating liquid contains water, water can infiltrate between layers of clay mineral particles to allow the clay mineral particles to swell, so that the coating liquid can easily have higher viscosity.

The total amount of the solvent in the coating liquid is preferably from 20 to 80% by weight, more preferably from 30 to 70% by weight, based on the total weight of the coating liquid. If the total amount of the solvent is too small, the coating liquid can have higher viscosity, which may reduce application stability. On the other hand, if the total amount of the solvent is too large, the coating liquid can have lower viscosity, which may cause the white pigment to settle in the coating liquid.

### (Clay mineral particles)

The coating liquid may also contain clay mineral particles. The addition of clay mineral particles to the coating liquid can increase the viscosity of the coating liquid and suppress the settling of the white pigment. Examples of the clay mineral particles include layered silicate mineral particles, imogolite particles, allophane particles, and the like. The layered silicate mineral is preferably a clay mineral having a mica structure, a kaolinite structure, or a smectite structure.

Layered silicate mineral particles can easily form a card house structure in the coating liquid being allowed to stand. If the layered silicate mineral particles form a card house structure, the viscosity of the coating liquid will significantly increase. On the other hand, the card house structure can easily collapse under a certain pressure, so that the viscosity of the coating liquid can decrease. Therefore, the coating liquid containing the layered silicate mineral particles can have high viscosity when allowed to stand, and can have low viscosity under a certain pressure.

Examples of the layered silicate mineral with such properties include natural or synthetic, smectite clay minerals such as hectorite, saponite, stevensite, beidellite, montmorillonite, nontronite, bentonite, and Laponite; swelling mica clay minerals such as Na-tetrasilicic fluoromica, Li-tetrasilicic fluoromica, Na-fluorotaeniolite, and Li-fluorotaeniolite; non-swelling mica clay minerals such as muscovite, phlogopite, fluorophlogopite, sericite, and tetrasilicic potassium mica; vermiculite and kaolinite; and any mixtures thereof.

Examples of commercially available clay mineral particles include Laponite XLG (synthetic hectorite analogue manufactured by Laporte Industries Inc, UK), Laponite RD (synthetic hectorite analogue manufactured by Laporte industries Inc., UK), Samabisu (synthetic hectorite analogue manufactured by Henkel, Germany), Sumecton SA-1 (saponite analogue manufactured by KUNIMINE INDUSTRIES CO., LTD.), BEN-GEL (natural bentonite available from HOJUN Co., Ltd.), Kunipia F (natural montmorillonite available from KUNIMINE INDUSTRIES CO., LTD.), VEEGUM (natural hectorite manufactured by Vanderbilt Minerals, LLC, US), Daimonaito (synthetic swelling mica manufactured by Topy Industries Ltd.), Micromica (synthetic non-swelling mica manufactured by CO-OP CHEMICAL CO., LTD.), Somasif (synthetic swelling mica manufactured by CO-OP CHEMICAL CO., LTD.), SWN (synthetic smectite manufactured by CO-OP CHEMICAL CO., LTD.), SWF (synthetic smectite manufactured by CO-OP CHEMICAL CO., LTD.), M-XF (muscovite manufactured by Repco Co., Ltd.), S-XF (phlogopite manufactured by Repco Co., Ltd.), PDM-800 (fluorophlogopite manufactured by Topy Industries Ltd.), SERICITE OC-100R (sericite manufactured by Ohchem Commerce Co., Ltd.), PDM-K(G) 325 (tetrasilicic potassium mica manufactured by Topy Industries Ltd.), and the like.

The clay mineral particles are preferably made of at least one selected from the group consisting of a layered silicate mineral, imogolite, and allophane. These particles have a very large surface area and can increase the viscosity of the coating liquid even when added in a small amount.

The content of the clay mineral particles is preferably from 0.1 to 5% by weight, more preferably from 0.2 to 2% by weight, based on the total weight of the coating liquid. If the content of the clay mineral particles is low, the viscosity of the coating liquid may be less likely to increase, and the white pigment may be more likely to settle. On the other hand, if the content of the clay mineral particles is too high, the coating liquid can have too high viscosity so that it may fail to be evenly discharged from a coater.

The surface of the clay mineral particles may be modified (surface-treated) with an ammonium salt or the like taking into account the compatibility with the solvent in the coating liquid.

### (Metal oxide fine particles)

The coating liquid may contain metal oxide fine particles with an average particle size of 5 nm to less than 100 nm. When the coating liquid contains the metal oxide fine particles, the resulting reflective layer can have irregularities on its surface, which can produce an anchoring effect between the reflective layer and the wavelength conversion layer. This can result in very good adhesion between the reflective layer and the wavelength conversion layer. When the coating liquid contains the metal oxide fine particles, stress on the coating can also be relaxed during the polycondensation of polysiloxane or during drying, so that the resulting reflective layer can be prevented from cracking.

The metal oxide fine particles may be of any type. Preferably, the metal oxide fine particles are made of at least one selected from the group of aluminum oxide, zirconium oxide, zinc oxide, tin oxide, yttrium oxide, cerium oxide, titanium oxide, copper oxide, and bismuth oxide because they are relatively easy to obtain.

The surface of the metal oxide fine particles may be treated with a silane coupling agent or a titanium coupling agent. The surface treatment can increase the compatibility of the metal oxide fine particles with polysiloxane or the solvent.

In view of each effect mentioned above, the metal oxide fine particles preferably have an average particle size of 5 to 100 nm, more preferably 5 to 80 nm, even more preferably 5 to 50 nm. When the average particle size falls within such ranges, fine irregularities can be formed on the surface of the reflective layer to produce the anchoring effect. The average particle size of the metal oxide fine particles can be measured by, for example, coulter counter method.

The metal oxide fine particles may also be porous. The porous metal oxide fine particles preferably have a specific surface area of 200 m²/g or more. When the metal oxide fine particles are porous, impurities can adsorb into the pores of the porous body.

The amount of the metal oxide fine particles in the coating liquid is preferably from 0.1 to 20% by weight, more preferably from 5 to 10% by weight, based on the total weight of the components other than the solvent in the coating liquid. If the amount of the metal oxide fine particles is too small, the anchoring effect will be insufficient. On the other hand, if the amount of the metal oxide fine particles is too large, the amount of polysiloxane will be relatively low, which may reduce the strength of the resulting reflective layer.

### (Inorganic particles)

The coating liquid may also contain inorganic particles with an average particle size of 100 nm to 100 µm. The gap formed at the interface between the white pigment particles and the clay mineral particles can be filled with the inorganic particles, so that the coating liquid can have higher viscosity.

Examples of the inorganic particles include oxide particles such as silicon oxide particles, fluoride particles such as magnesium fluoride particles, or mixtures thereof. The inorganic particles are preferably oxide particles, more preferably silicon oxide particles.

The surface of the inorganic particles may be treated with a silane coupling agent or a titanium coupling agent. The surface treatment can increase the compatibility of the inorganic particles with polysiloxane or the solvent.

The content of the inorganic particles in the coating liquid is preferably from 0.1 to 10% by weight, more preferably from 0.2 to 5% by weight, based on the total weight of the coating liquid. If the content of the inorganic particles is more than 10% by weight, cracking can easily occur in the process of forming the reflective layer. If it is less than 0.1% by weight, the effect of increasing the viscosity of the coating liquid will be low.

For the filling of the gap formed at the interface between the white pigment particles and the clay mineral particles, the inorganic particles preferably have an average particle size of 100 nm to 50 µm, more preferably 1 µm to 30 µm. The average particle size of the inorganic particles can be measured by, for example, coulter counter method.

### (Silane coupling agent)

The coating liquid preferably further contains a silane coupling agent. The silane coupling agent in the coating liquid can increase the adhesion between the resulting reflective layer and the substrate, so that the resulting LED device can have higher durability.

Examples of the silane coupling agent include vinyltrimethoxysilane, vinyltriethoxysilane, 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropyltriethoxysilane, 3-acryloxypropyltrimethoxysilane, N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-triethoxysilyl-N-(1,3-dimethyl-butylidene)propylamine, N-phenyl-3-aminopropyltriethoxysilane, N-(vinylbenzyl)-2-aminoethyl-3-aminopropyltrimethoxysilane hydrochloride, 3-ureidopropyltrimethoxysilane, 3-chloropropyltrimethoxysilane, 3-mercaptopropylmethyldimethoxysilane, 3-mercaptopropyltrimethoxysilane, bis(triethoxysilylpropyl)tetrasulfide, 3-isocyanatopropyltriethoxysilane, and the like. The coating liquid may contain one or more of these silane coupling agents.

The amount of the silane coupling agent in the coating liquid is preferably from 0.5 to 10% by weight, more preferably from 1 to 7% by weight, based on the total weight of the components other than the solvent in the coating liquid. If the amount of the silane coupling agent is too small, the adhesion between the resulting reflective layer and the substrate may fail to increase sufficiently, and if it is too large, heat resistance may decrease.

### (Metal alkoxide or metal chelate)

The coating liquid may also contain a metal alkoxide or chelate containing a metal element other than Si. The metal alkoxide or the metal chelate can form metalloxane bonding with the silane compound or hydroxyl groups on the surface of the substrate in the process of forming the reflective layer. The metalloxane bonding is very strong. Therefore, when the coating liquid contains the metal alkoxide or the metal chelate, the resulting reflective layer can have improved adhesion to the substrate.

In a film (reflective layer) obtained by curing the coating liquid, part of the metal alkoxide or chelate can form a nano-sized cluster having metalloxane bonding. The cluster can have a photocatalytic effect, which makes it possible to oxidize highly metal-corrosive sulfide gas and the like in the vicinity of the LED device to less corrosive sulfur dioxide gas and the like.

The metal element in the metal alkoxide or chelate is preferably a group 4 or 13 metal element other than Si, and the metal alkoxide or chelate is preferably represented by formula (V) below.

M^{m+}XₙYₘ₋ₙ (V)

In formula (V), M is a group 4 or 13 metal element (exclusive of Si), m is the valence of M (3 or 4), X is a hydrolyzable group, n is the number of the X groups (an integer of 2 to 4), provided that m ≥ n, and Y is a monovalent organic group.

In formula (V), the group 4 or 13 metal element represented by M is preferably aluminum, zirconium, or titanium, more preferably zirconium. A product obtained by curing a zirconium alkoxide or chelate has no absorption wavelength in the emission wavelength region of general LED devices (particularly blue light (wavelength 420 to 485 nm)). In other words, the product obtained by curing hardly absorbs light from LED elements.

In formula (V), the hydrolyzable group represented by X may be a group that can be hydrolyzed with water to form a hydroxyl group. Preferred examples of the hydrolyzable group include lower alkoxy groups of 1 to 5 carbon atoms, an acetoxy group, a butanoxime group, a chloro group, and the like. In formula (V), the groups represented by X may be the same or different.

The hydrolyzable group represented by X can be hydrolyzed and released in the process of forming the reflective layer. Therefore, the compound produced from the group represented by X after the hydrolysis is preferably neutral and easy to boil. Thus, the group represented by X is preferably a lower alkoxy group of 1 to 5 carbon atoms, more preferably a methoxy group or an ethoxy group.

In formula (V), the monovalent organic group represented by Y may be a monovalent organic group commonly contained in silane coupling agents. Specifically, the monovalent organic group may be an aliphatic, alicyclic, aromatic, or alicyclic aromatic group of 1 to 1,000 carbon atoms, preferably 500 or less carbon atoms, more preferably 100 or less carbon atoms, even more preferably 40 or less carbon atoms, further more preferably 6 or less carbon atoms. The organic group represented by Y may also be a group including aliphatic, alicyclic, aromatic, and alicyclic aromatic groups bonded through a linking group. The linking group may be an atom such as 0, N, or S or an atomic group including such an atom.

The organic group represented by Y may have a substituent. Examples of the substituent include halogen atoms such as F, Cl, Br, and I; and organic groups such as vinyl, methacryloxy, acryloxy, styryl, mercapto, epoxy, epoxycyclohexyl, glycidoxy, amino, cyano, nitro, sulfonate, carboxy, hydroxy, acyl, alkoxy, imino, and phenyl groups.

Examples of aluminum metal alkoxide or chelate represented by formula (V) include aluminum triisopropoxide, aluminum tri-n-butoxide, aluminum tri-tert-butoxide, aluminum triethoxide, and the like.

Examples of zirconium metal alkoxide or chelate represented by formula (V) include zirconium tetramethoxide, zirconium tetraethoxide, zirconium tetra-n-propoxide, zirconium tetra-i-propoxide, zirconium tetra-n-butoxide, zirconium tetra-i-butoxide, zirconium tetra-tert-butoxide, zirconium dimethacrylate dibutoxide, zirconium dibutoxy bis(ethylacetoacetate), and the like.

Examples of titanium metal alkoxide or chelate represented by formula (V) include titanium tetraisopropoxide, titanium tetra-n-butoxide, titanium tetra-i-butoxide, titanium methacrylate triisopropoxide, titanium tetramethoxypropoxide, titanium tetra-n-propoxide, titanium tetraethoxide, titanium lactate, titanium bis(ethylhexoxy)bis(2-ethyl-3-hydroxyhexoxide), titanium acetylacetonate, and the like.

It will be understood that the metal alkoxides or chelates listed above are only some of the commercially easily available organic metal alkoxides or chelates. The metal alkoxides or chelates shown in a list of coupling agents and related products in "Kappuringu-zai Saiteki Riyo Gijutsu (Techniques for the optimal use of coupling agents)," Chapter 9, published by Kagaku Gijutsu Sogo Kenkyujo may also be used in the present invention.

The amount of the metal alkoxide or chelate in the coating liquid is preferably from 1 to 10% by weight, more preferably from 2 to 7% by weight, based on the total weight of the components other than the solvent in the coating liquid. If the content of the metal alkoxide or chelate is too low, it will not be effective in increasing the adhesion, and if the content of the metal alkoxide or chelate is too high, the coating liquid will have lower storage stability.

### (Liquid preparation method)

The coating liquid preparation method may be a method of mixing at once raw materials including the white pigment, the silane compound or compounds, the solvent, the metal oxide fine particles, the inorganic particles, the clay mineral particles, and the silane coupling agent. Alternatively, the coating liquid preparation method may include mixing two or more raw materials in advance and then mixing liquid mixtures.

To increase the uniformity of the coating liquid, it is preferable to disperse all or some of the raw materials for the coating liquid by using any of the apparatuses shown below. In this case, in order to increase the thickening effect, either or both of the inorganic particles and the clay mineral particles may be dispersed in the solvent, and then the remaining components may be mixed with the dispersion.

To increase the dispersibility of the white pigment, it is preferable to disperse the white pigment at least once with any of the apparatuses shown below. When the white pigment is dispersed with any of the apparatuses shown below, the aggregation of the white pigment can be reduced so that a high-reflectance, denser coating film can be obtained.

### Mixing/dispersing apparatus

The liquid mixture can be stirred and dispersed using, for example, a magnetic stirrer, an ultrasonic disperser, a homogenizer, a stirring mill, a blade kneader, a thin-film spin type disperser, a high-pressure impact disperser, a planetary centrifugal mixer, or the like.

The liquid mixture may be stirred using any known mixer. Examples include media-less stirring devices such as ULTRA-TURRAX (manufactured by IKA Japan), T.K. HOMO MIXER (manufactured by PRIMIX Corporation), T.K. PIPELINE-HOMO MIXER (manufactured by PRIMIX Corporation), T.K. FILMIX (manufactured by PRIMIX Corporation), CLEAMIX (manufactured by M Technique Co., Ltd.), CLEA SS5 (manufactured by M Technique Co., Ltd.), CAVITRON (EUROTEC CO., LTD.), and Fine Flow Mill (Pacific Machinery & Engineering Co., Ltd.); media stirring devices such as Viscomill (Aimex Co. , Ltd.), Apex Mill (Kotobuki Industries Co. , Ltd.), Star Mill (Ashizawa Finetech Ltd.), DMPA S Super Flow (manufactured by Nippon Eirich Co. , Ltd.), MP Mill (manufactured by INOUE MFG., INC.), Spike Mill (manufactured by INOUE MFG., INC.), Mighty Mill (manufactured by INOUE MFG. , INC.), and SC Mill (manufactured by Mitsui Kozan Co., Ltd.); and high-pressure impact dispersers such as Ultimizer (manufactured by Sugino Machine Limited), Nanomizer (manufactured by Yoshida Kikai Co., Ltd.), and NANO3000 (manufactured by Beryu Co., Ltd.). A planetary centrifugal mixer such as AWATORIRENTARO (THINKY MIXER) (manufactured by THINKY CORPORATION) and an ultrasonic disperser are also preferably used.

The coating liquid preferably has a viscosity of more than 5 mPa·s to 500 mPa·s. If the viscosity of the coating liquid is lower than the lower limit, the white pigment may settle so that changes in concentration may easily occur inside the coater. This may result in degradation of application stability. On the other hand, if the viscosity is higher than the upper limit, the pressure loss in a dispenser will gradually decrease so that the discharge amount will increase. This may result in degradation of application stability.

### (Application method and curing method)

The coating liquid may be applied by any method such as a coating method using a common coater such as a dispenser, a jet dispenser, or a spray device. The method and conditions for curing the coating liquid may be appropriately selected depending on the type of the silane compound or other factors. An example of the curing method may be curing by heating.

Specifically, after the coating liquid is applied, the coating film is heated. The heating temperature is preferably from 20 to 200°C, more preferably from 25 to 150°C. If the heating temperature is less than 20°C, the solvent in the coating film may fail to sufficiently evaporate. On the other hand, a temperature of more than 200°C may have an adverse effect on LED elements. The drying and curing time is preferably from 0.1 to 120 minutes, more preferably from 5 to 60 minutes in view of production efficiency.

### (Applications)

Hereinafter, an LED device including a reflective layer made of a product obtained by curing the coating liquid will be described.

### [LED device]

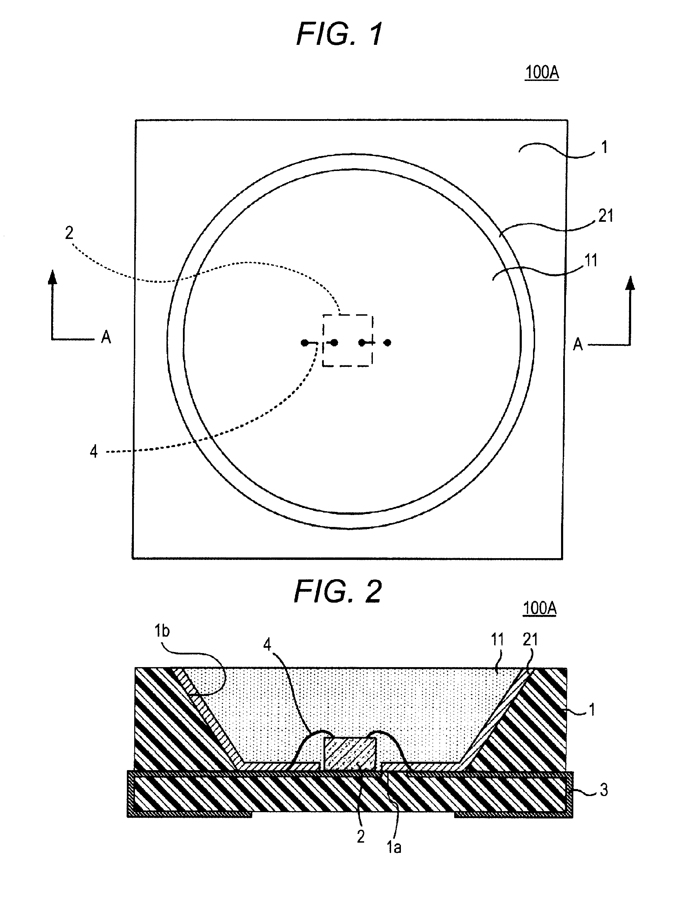

Fig. 1 is a top view showing an LED device 100A according to an embodiment. Fig. 2 is a cross-sectional view showing the LED device 100A according to an embodiment. Hereinafter, a description will be given of an example where a wire bonded LED element 2 is used.

As shown in Fig. 2, the LED device 100A according to an embodiment includes a substrate 1, an LED element 2 disposed on the substrate 1, a reflective layer 21 disposed at least around the LED element 2 on the substrate 1, and a wavelength conversion layer 11 disposed over the LED element 2 and the reflective layer 21.

Therefore, the LED device 100A according to an embodiment has a reflective layer 21 provided to reflect emitted light and the like from the LED element 2 toward the light extraction surface. The reflective layer 21 is obtained by heating and curing the coating liquid according to the embodiment described above.

As shown in Fig. 2, the LED element 2 is disposed on the bottom surface 1a of the truncated cone-shaped cavity (recess) of the substrate 1. The substrate 1 is provided with a metal part (metal electrode part) 3, and the LED element 2 is electrically connected to the metal part (metal electrode part) 3 via wiring 4.

The reflective layer 21 is disposed on a certain area of the substrate 1, other than the area where the LED element 2 is disposed. The reflective layer 21 is mortar-shaped and formed to extend from the bottom surface 1a to the side surface 1b of the truncated cone-shaped cavity (recess) of the substrate 1. When viewed from the top, the reflective layer 21 has a ring shape, which is formed around the circumference of the wavelength conversion layer 11 concentrically with the wavelength conversion layer 11.

### (1) Substrate

The substrate 1 preferably has insulating properties and heat resistance and is preferably made of ceramic resin or heat-resistant resin. Examples of heat-resistant resin include liquid crystal polymers, polyphenylene sulfide, aromatic nylon, epoxy resin, hard silicone resin, polyphthalamide, and the like.

The substrate 1 may also contain an inorganic filler. The inorganic filler may be titanium oxide, zinc oxide, alumina, silica, barium titanate, calcium phosphate, calcium carbonate, white carbon, talc, magnesium carbonate, boron nitride, glass fibers, or the like.

### (2) LED element

The wavelength of the light emitted by the LED element 2 is not restricted. For example, the LED element 2 may be configured to emit blue light (light of about 420 nm to about 485 nm) or violet light.

The LED element 2 may have any structure. When configured to emit blue light, the LED element 2 may be a multilayer structure including an n-GaN compound semiconductor layer (clad layer), an InGaN compound semiconductor layer (light-emitting layer), a p-GaN compound semiconductor layer (clad layer), and a transparent electrode layer. The LED element 2 may have a light-emitting surface of, for example, 200-300 µm x 200-300 µm. The LED element 2 generally has a height of about 50 to about 200 µm. In the LED device 100A shown in Figs. 1 and 2, only a single LED element 2 is disposed on the substrate 1. Alternatively, however, two or more LED elements 2 may be disposed on the substrate 1.

### (3) Reflective layer

The reflective layer 21 is provided to reflect, toward the light extraction surface of the LED device 100A, light emitted from the LED element 2 and fluorescent light emitted from a fluorescent material in the wavelength conversion layer 11. The reflective layer 21 provided increases the quantity of light extracted from the light extraction surface of the LED device 100A.

The reflective layer 21 is formed on at least a certain area of the surface of the substrate 1, other than the area where the LED element 2 is disposed. The area where the LED element 2 is disposed refers to an area including the light-emitting surface of the LED element 2 and a part of connection between the LED element 2 and the metal part (metal electrode part) 3. In other words, the reflective layer 21 is formed in an area that does not interfere with the light emission from the LED element 2 or the connection between the LED element 2 and the metal part (metal electrode part) 3. For example, as shown in Fig. 2, the reflective layer 21 is formed in at least an area around the periphery of the LED element 2.

When the substrate 1 has a cavity as shown in Figs. 1 and 2, it is preferable to form the reflective layer 21 also on the inner wall surface 1b of the cavity. The reflective layer 21 formed on the inner wall surface 1b of the cavity can reflect light traveling in a direction horizontal to the surface of the wavelength conversion layer 11 so that the reflected light can be extracted.

Conventional reflective layers for LED devices are generally metal plating films. However, such metal plating films cannot be formed over the surface of a substrate because electrical conduction needs to be prevented. Therefore, there has been a problem in that light is absorbed by the substrate at the area not plated with metal. There is also proposed a reflective layer made of a resin layer containing dispersed light-diffusing particles. Unfortunately, such a reflective layer can be easily degraded by emitted light and heat from an LED element. During the long-term use of the LED device, therefore, the degradation of the resin can decrease the ability to extract light from the LED device.

In contrast, the reflective layer 21 of the LED device 100A according to the embodiment is a layer composed of the white pigment bound with a binder (a product obtained by curing the silane compound), which does not conduct electricity. In the LED device 100A according to the embodiment, therefore, the reflective layer 21 can be formed on any area of the substrate 1 including a space between metal parts. This makes it possible to efficiently extract light from the LED device 100A. In addition, the reflective layer 21 of the LED device 100A according to the embodiment is hardly decomposed even when exposed to heat and light from the LED element 2. Therefore, the light reflecting properties of the reflective layer 21 does not change over a long period of time, so that the light extraction performance remains good for a long period of time.

The reflective layer 21 preferably has a thickness of 5 to 30 µm, more preferably 5 to 20 µm. If the thickness of the reflective layer 21 is more than 30 µm, the reflective layer 21 may be more likely to crack. On the other hand, if the thickness of the reflective layer 21 is less than 5 µm, the reflective layer 21 may have insufficient light reflecting properties and fail to increase the light extraction efficiency.

The reflective layer 21 contains the white pigment and a binder (a polymer of the silane compound). The amount of the white pigment in the reflective layer 21 is preferably from 60 to 95% by weight, more preferably from 70 to 90% by weight, based on the total weight of the reflective layer 21. If the amount of the white pigment is less than 60% by weight, the reflective layer 21 may fail to have sufficiently high light reflecting properties.

On the other hand, the amount of the binder (a polymer of the silane compound) in the reflective layer 21 is preferably from 5 to 40% by weight, more preferably from 10 to 30% by weight, based on the total weight of the reflective layer 21. If the amount of the binder is less than 5% by weight, the binder may fail to sufficiently bind the white pigment so that a powder of the pigment can easily appear on the surface of the reflective layer 21. On the other hand, if the amount of the binder is more than 40% by weight, the amount of the white pigment will be relatively low so that the light reflecting properties of the reflective layer 21 may fail to increase sufficiently.

As mentioned above, the binder contains a polymer (a product of curing) of the trifunctional, tetrafunctional, or bifunctional silane compound monomer, or contains a polymer (a product of curing) of an oligomer of any of these silane compound monomers.

In this case, the amount of the bifunctional silane compound-derived component (hereinafter also referred to as the "bifunctional component") is less than 20% by mole based on the total amount of the silane compound-derived components in the binder of the reflective layer 21. The bifunctional component in the binder allows the reflective layer 21 to resist cracking. However, if the amount of the bifunctional component is 20% by mole or more, the content of polar components including Si-O will be relatively low, so that the reflective layer 21 may have reduced adhesion to the substrate 1 and peeling may easily occur at the interface between them.

The molar ratio of the tetrafunctional silane compound-derived component (hereinafter also referred to as the "tetrafunctional component") to the trifunctional silane compound-derived component (hereinafter also referred to as the "trifunctional component") in the binder is 0 to 3.

The tetrafunctional component in the binder can improve the adhesion of the reflective layer 21 to the substrate 1. However, if the molar ratio is more than 3, the silane compound polymer (polysiloxane) will have a higher degree of cross-linkage, so that the reflective layer 21 will be more likely to crack.

The contents of the bifunctional, trifunctional, and tetrafunctional silane compound components in the binder can be determined by the solid-state Si-NMR described above.

### (Other embodiments)

Although the present invention has been described with reference to some embodiments, the description and drawings constituting part of the disclosure should not be construed as limiting the present invention. From the disclosure, various alternative embodiments, examples, and operational technologies will be apparent to those skilled in the art.

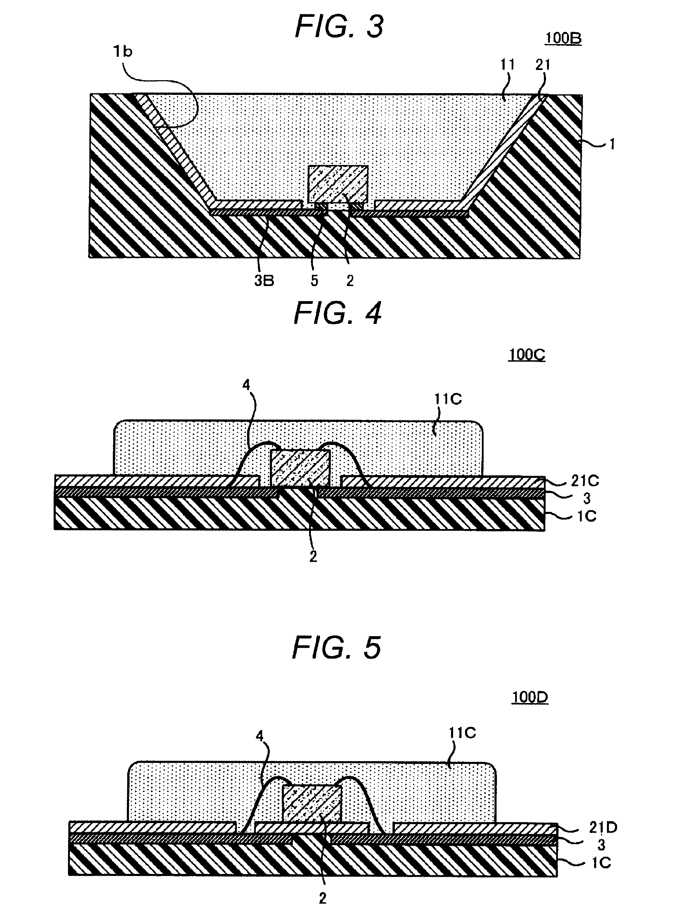

The LED device 100A may have any configuration. The LED element 2 is not limited to a wire bonded type and may be, for example, a flip-chip type, which is connected, as shown in Fig. 3, via a bump electrode 5 and a metal part (metal electrode part) 3B provided on the substrate 1. The shape of the cavity shown in Figs. 1 and 2 is also not restricted. The cavity may be, for example, truncated pyramid-shaped, circular column-shaped, rectangular column-shaped, or any other shape.

Alternatively, the substrate 1 may be flat plate-shaped, for example, as shown in Fig. 4 or 5.

As shown in Fig. 5, for example, the reflective layer 21D may be formed not only in a region around the periphery of the LED element 2 but also between the substrate 1C and the LED element 2. In other words, the LED element 2 may be disposed on the reflective layer 21D. The reflective layer 21D formed between the substrate 1C and the LED element 2 can reflect the light sneaking into the back side of the LED element 2 to increase the efficiency of light extraction from the LED device 100D.

Thus, it will be understood that the present invention encompasses various embodiments and the like not described herein. Therefore, the technical scope of the present invention should be determined only based on matters to define the present invention in claims reasonable from the description.

### Examples

### Preparation of silane compound solutions 1 to 10

The components were mixed in the ratio shown in Table 1 below to form each of silane compound solutions 1 to 10.

**[Table 1]**

| | Tetrafunctional component | | | Trifunctional component | | | Bifunctional component | | | Solvent | | Water | Acid | | R4 / R3 | R2 |
|---|---|---|---|---|---|---|---|---|---|---|---|---|---|---|---|---|
| | Compound | Molar percentage in silane compounds | Weight percentage in coating liquid | Compound | Molar percentage in silane compounds | Weight percentage in coating liquid | Compound | Molar percentage in silane compounds | Weight percentage in coating liquid | Type | Weight percentage in coating liquid | Weight percentage in coating liquid | Type | Weight percentage in coating liquid | | |
| Silane compound solution 1 | Tetramethoxysilane | 76.0 | 7.8 | Methyltrimethoxysilane | 24.0 | 2.2 | | | | Methanol / acetone (1/1) | 70 | 19.99 | Nitric acid | 0.01 | 3.2 | 0.0 |
| Silane compound solution 2 | Tetramethoxysilane | 72.9 | 7.5 | Methyltrimethoxysilane | 27.1 | 2.5 | | | | Methanol/acetone (1/1) | 70 | 19.99 | Nitric acid | 0.01 | 2.7 | 0.0 |
| Silane compound solution 3 | | | | Methyltriethoxysilane | 100.0 | 20 | | | | Ethanol | 60 | 19.99 | Hydrochloric acid | 0.01 | 0.0 | 0.0 |
| Silane compound solution 4 | | | | Methyltriethoxysilane | 82.5 | 17 | Dimethyldiethoxysilane | 17.5 | 3 | Ethanol | 60 | 19.99 | Hydrochloric acid | 0.01 | 0.0 | 17.5 |
| Silane compound solution 5 | | | | Methyltriethoxysilane | 76.9 | 16 | Dimethyldiethoxysilane | 23.1 | 4 | Ethanol | 60 | 19.99 | Hydrochloric acid | 0.01 | 0.0 | 23.1 |
| Silane compound solution 6 | Tetraethoxysilane | 32.3 | 4.3 | Methyltrimethoxysilane | 37.8 | 4.3 | Dimethyldimethoxysilane | 18.2 | 1.4 | Methanol | 70 | 19.99 | Nitric acid | 0.01 | 0.9 | 18.2 |
| Silane compound solution 7 | Tetraethoxysilane | 30.9 | 3.9 | Methyltrimethoxysilane | 36.1 | 3.9 | Dimethyldimethoxysilane | 21.9 | 1.6 | Methanol | 70 | 19.99 | Nitric acid | 0.01 | 0.9 | 21.9 |
| Silane compound solution 8 | Tetraethoxysilane | 61.6 | 7.2 | Methyltrimethoxysilane | 18.0 | 1.8 | Dimethyldimethoxysilane | 14.8 | 1 | Methanol | 70 | 19.99 | Nitric acid | 0.01 | 3.4 | 14.8 |
| Silane compound solution 9 | Tetramethoxysilane | 49.9 | 10.7 | Methyltrimethoxysilane | 50.1 | 9.6 | | | | n - butanol/methyl -3- methoxypropionate (1/1) | 70.5 | 9.19 | Nitric acid | 0.01 | 1.0 | 0.0 |
| Silane compound solution 10 | | | | Methyltrimethoxysilane | 100.0 | 15 | | | | Ethylene glycol dimethyl ether | 80 | 4.99 | Nitric acid | 0.01 | 0.0 | 0.0 |

### (Silane compound solution 1)

A mixture of 7.8% by weight of tetramethoxysilane, 2.2% by weight of methyltrimethoxysilane, 35% by weight of methanol, 35% by weight of acetone, 19.99% by weight of water, and 0.01% by weight of nitric acid was prepared and stirred at 23°C for 3 hours. The mixture was then allowed to react under stirring at 26°C for 3 days, so that silane compound solution 1 containing a polysiloxane oligomer was obtained.

The molecular weight of the polysiloxane oligomer in the resulting solution was measured by GPC. As a result, the polysiloxane oligomer was determined to have a polystyrene-equivalent weight average molecular weight of 1,800.

The solution was cured at 150°C to form a solid sample, which was subjected to solid-state Si-NMR measurement. As a result, peaks corresponding to Q and T components were observed, and the ratio R4/R3 between the Q and T components was determined to be 3.2 from the respective area ratios.

### (Silane compound solution 2)

A mixture of 7.5% by weight of tetramethoxysilane, 2.5% by weight of methyltrimethoxysilane, 35% by weight of methanol, 35% by weight of acetone, 19.99% by weight of water, and 0.01% by weight of nitric acid was prepared and stirred at 23°C for 3 hours. The mixture was then allowed to react under stirring at 26°C for 3 days, so that silane compound solution 2 containing a polysiloxane oligomer was obtained.

The molecular weight of the polysiloxane oligomer in the resulting solution was measured by GPC. As a result, the polysiloxane oligomer was determined to have a polystyrene-equivalent weight average molecular weight of 2,000.

The solution was cured at 150°C to form a solid sample, which was subjected to solid-state Si-NMR measurement. As a result, peaks corresponding to Q and T components were observed, and the ratio R4/R3 between the Q and T components was determined to be 2.7 from the respective area ratios.

### (Silane compound solution 3)

Silane compound solution 3 was obtained by mixing 20% by weight of methyltriethoxysilane, 60% by weight of ethanol, 19.99% by weight of water, and 0.01% by weight of hydrochloric acid. A solid sample obtained by curing the solution at 150°C was subjected to solid-state Si-NMR measurement. As a result, only peaks corresponding to T components were observed.

### (Silane compound solution 4)

Silane compound solution 4 containing a polysiloxane oligomer was obtained by mixing 17% by weight of methyltriethoxysilane, 3% by weight of dimethyldiethoxysilane, 60% by weight of ethanol, 19.99% by weight of water, and 0.01% by weight of hydrochloric acid and stirring the mixture at 28°C for 2 days.

The molecular weight of the polysiloxane oligomer in the resulting solution was measured by GPC. As a result, the polysiloxane oligomer was determined to have a polystyrene-equivalent weight average molecular weight of 2,300.

The solution was cured at 150°C to form a solid sample, which was subjected to solid-state Si-NMR measurement. As a result, peaks corresponding to T and D components were observed. As a result of the calculation of the peak area ratio, the content of the D component in all the silicon compounds was determined to be 17.5% by mole.

### (Silane compound solution 5)

Silane compound solution 5 containing a polysiloxane oligomer was obtained by mixing 16% by weight of methyltriethoxysilane, 4% by weight of dimethyldiethoxysilane, 60% by weight of ethanol, 19.99% by weight of water, and 0.01% by weight of hydrochloric acid and stirring the mixture at 28 °C for 2 days.

The molecular weight of the polysiloxane oligomer in the resulting solution was measured by GPC. As a result, the polysiloxane oligomer was determined to have a polystyrene-equivalent weight average molecular weight of 2,400.

The solution was cured at 150°C to form a solid sample, which was subjected to solid-state Si-NMR measurement. As a result, peaks corresponding to T and D components were observed. As a result of the calculation of the peak area ratio, the content of the D component in all the silicon compounds was 23.1% by mole.

### (Silane compound solution 6)

Silane compound solution 6 containing a polysiloxane oligomer was obtained by mixing 4.3% by weight of tetraethoxysilane, 4.3% by weight of methyltrimethoxysilane, 1.4% by weight of dimethyldimethoxysilane, 70% by weight of methanol, 19.99% by weight of water, and 0.01% by weight of nitric acid and stirring the mixture at 25°C for 6 days.

The molecular weight of the polysiloxane oligomer in the resulting solution was measured by GPC. As a result, the polysiloxane oligomer was determined to have a polystyrene-equivalent weight average molecular weight of 1,600.

The solution was cured at 150°C to form a solid sample, which was subjected to solid-state Si-NMR measurement. As a result, peaks corresponding to Q, T, and D components were observed. As a result of the calculation of the peak area ratio, the ratio R4/R3 between the Q and T components was 0.9, and the content of the D component in all the silicon compounds was 18.2% by mole.

### (Silane compound solution 7)

Silane compound solution 7 containing a polysiloxane oligomer was obtained by mixing 3.9% by weight of tetraethoxysilane, 3.9% by weight of methyltrimethoxysilane, 1.6% by weight of dimethyldimethoxysilane, 70% by weight of methanol, 19.99% by weight of water, and 0.01% by weight of nitric acid and stirring the mixture at 25°C for 6 days.

The molecular weight of the polysiloxane oligomer in the resulting solution was measured by GPC. As a result, the polysiloxane oligomer was determined to have a polystyrene-equivalent weight average molecular weight of 1,500.

The solution was cured at 150°C to form a solid sample, which was subjected to solid-state Si-NMR measurement. As a result, peaks corresponding to Q, T, and D components were observed. As a result of the calculation of the peak area ratio, the ratio R4/R3 between the Q and T components was 0.9, and the content of the D component in all the silicon compounds was 21.9% by mole.

### (Silane compound solution 8)

Silane compound solution 8 containing a polysiloxane oligomer was obtained by mixing 7.2% by weight of tetraethoxysilane, 1.8% by weight of methyltrimethoxysilane, 1% by weight of dimethyldimethoxysilane, 70% by weight of methanol, 19.99% by weight of water, and 0.01% by weight of nitric acid and stirring the mixture at 25°C for 6 days.

The molecular weight of the polysiloxane oligomer in the resulting solution was measured by GPC. As a result, the polysiloxane oligomer was determined to have a polystyrene-equivalent weight average molecular weight of 1,600.

The solution was cured at 150°C to form a solid sample, which was subjected to solid-state Si-NMR measurement. As a result, peaks corresponding to Q, T, and D components were observed. As a result of the calculation of the peak area ratio, the ratio R4/R3 between the Q and T components was 3.4, and the content of the D component in all the silicon compounds was 14.8% by mole.

### (Silane compound solution 9)

A mixture of 9.6% by weight of methyltrimethoxysilane, 10.7% by weight of tetramethoxysilane, 70.5% by weight of n-butanol/methyl-3-methoxypropionate (1 : 1 solution), 9.19% by weight of water, and 0.01% by weight of nitric acid was subjected to a hydrolysis reaction by being stirred for 3 hours.

The mixture was then allowed to react at 26°C for 2 days, so that a reaction solution containing a siloxane polymer was obtained. The siloxane polymer in the reaction solution had a weight average molecular weight (Mw) of 1,600.

Silane compound solution 9 for a coating liquid for forming silica-based coating films was obtained by mixing 400 g of the reaction solution with 100 g of n-butanol and 100g of methyl-3-methoxypropionate.

The solution was cured at 150°C to form a solid sample, which was subjected to solid-state Si-NMR measurement. As a result, peaks corresponding to Q and T components were observed. The ratio R4/R3 between the Q and T components was determined to be 1.0 from the respective area ratios.

### (Silane compound solution 10)

A solution of 15% by weight of methyltriethoxysilane in 80% by weight of ethylene glycol dimethyl ether was prepared and stirred. A mixture of 4.99% by weight of pure water and 0.01% by weight of concentrated nitric acid was added dropwise to the solution being stirred slowly. Subsequently, the resulting mixture was stirred for about 3 hours and then allowed to stand at room temperature for 6 days to form a solution. The solution was distilled under a reduced pressure of 120 to 140 mmHg at 40°C for 1 hour to give silane compound solution 10.

The molecular weight of a polysiloxane oligomer in the resulting solution was measured by GPC. As a result, the polysiloxane oligomer was determined to have a polystyrene-equivalent weight average molecular weight of 1,800.

The solution was cured at 150°C to form a solid sample, which was subjected to solid-state Si-NMR measurement. As a result, only peaks corresponding to T components were observed.

### Preparation of liquid formulations 1 to 12

The components were mixed in the ratio shown in Table 2. The resulting liquid mixture was dispersed by the method or means shown in Table 2 to form each of liquid formulations 1 to 12. The abbreviations in Tables 2 and 3 represent the components shown below.

**[Table 2]**

| | Solvent (parts by weight) | | | | Inorganic particles (parts by weight) | | | | Metal oxide fine particles (parts by weight) | | | Clay mineral particles (parts by weight) | | | | | Silane coupling agent (parts | | | | Dispersion means |
|---|---|---|---|---|---|---|---|---|---|---|---|---|---|---|---|---|---|---|---|---|---|
| | BD | PG | IPA | EtOH | Sylysia 470 | SP-1 | VM 2270 | SS-50F | Alu-C | Zr-210 | Tl-210 | M-100 | ME-100 | SWN | Kunipia F | Imogolite | KBM-403 | KBM-903 | KBM-802 | KBE-846 | |
| Liquid formulation 1 | 100 | | | | | | | | | | | | | | | | | | | | - |
| Liquid formulation 2 | 55 | | 40 | | 5 | | | | | | | | | | | | | | | | Ultrasonic dispersion |
| Liquid formulation 3 | 64 | | | 30 | | 3 | | | | 3 | | | | | | | | | | | AWATORIRENTARO |
| Liquid formulation 4 | | 70 | 25 | | | | | | | | | 5 | | | | | | | | | Apex Mill |
| Liquid formulation 5 | | 70 | 28 | | | | | | | | | | | | | 2 | | | | | Stirrer |
| Liquid formulation 6 | 25 | 25 | | 45 | | | 3 | | | | | | 2 | | | | | | | | HOMO MIXER |
| Liquid formulation 7 | 60 | | 33 | | | | | 5 | | | | | | | | 2 | | | | | FILMIX |
| Liquid formulation 8 | 40 | 20 | 34 | | | | | | 3 | | | | | 3 | | | | | | | CLEAMIX |
| Liquid formulation 9 | 80 | | | 18 | | | | | | | | | | | | | 1 | | | | Ultimizer |
| Liquid formulation 10 | 60 | | | 32 | 3 | | | | | | | | | | 3 | | | 2 | | | Nanomizer |
| Liquid formulation 11 | 60 | | | 32 | 3 | | | | | | | | | | 3 | | | | 2 | | Stirrer |
| Liquid formulation 12 | 35 | 30 | | 26 | | 2 | | | | | 3 | | 2 | | | | | | | 2 | Stirrer |

### (Solvent)

BD: 1,3-butanediol
PG: propylene glycol
IPA: isopropyl alcohol
EtOH: ethanol

### (Inorganic particles)

Sylysia 470: silica (Sylysia 470 manufactured by Fuji Silysia Chemical Ltd.) 14 µm in average particle size
SP-1: silica (Micro Bead SP-1 manufactured by JGC Catalysts and Chemicals Ltd.) 5 µm in average particle size
VM2270: silica (VM-2270 manufactured by Dow Corning Corporation) 5 to 15 µm in average particle size
SS-50F: silica (Nipsil SS-50F manufactured by Tosoh Silica Corporation) 1.2 µm in average particle size

### (Metal oxide fine particles)

Alu-C: alumina (AEROXIDE Alu-C manufactured by NIPPON AEROSIL CO., LTD.) 13 nm in average primary particle size
ZR-210: ZrO₂ particles (TECNADIS-Zr-210 manufactured by TECNAN) 10 to 15 nm in average particle size
Ti-210: TiO₂ particles (TECNADIS-TI-210 manufactured by TECNAN) 10 to 15 nm in average particle size

### (Clay mineral particles)

MK-100: synthetic mica (Micromica MK-100 manufactured by CO-OP CHEMICAL CO., LTD.)
ME-100: synthetic mica (Somasif ME-100 manufactured by CO-OP CHEMICAL CO., LTD.)
SWN: smectite (Lucentite SWN manufactured by CO-OP CHEMICAL CO., LTD.)
Kunipia F: montmorillonite (Kunipia F manufactured by KUNIMINE INDUSTRIES CO., LTD.)

### (Silane coupling agent)

KBM-403: 3-glycidoxypropyltrimethoxysilane (KBM-403 manufactured by Shin-Etsu Chemical Co., Ltd.)
KBM-903: 3-aminopropyltrimethoxysilane (KBM-903 manufactured by Shin-Etsu Chemical Co., Ltd.)
KBM-802: 3-mercaptopropylmethyldimethoxysilane (KBM-802 manufactured by Shin-Etsu Chemical Co., Ltd.)
KBE-846: bis(triethoxysilylpropyl)tetrasulfide (KBE-846 manufactured by Shin-Etsu Chemical Co., Ltd.)

### (White pigment)

Titanium oxide: CR-93 manufactured by ISHIHARA SANGYO KAISHA, LTD.
Titanium oxide: CR-95 manufactured by ISHIHARA SANGYO KAISHA, LTD.
Aluminum oxide: HD-11 manufactured by Nikkato Corporation
Barium sulfate: NFJ-3-1999 manufactured by SANSEI & CO., LTD.
Boron nitride: AP-100S manufactured by MARUKA CORPORATION

### [Examples 1 to 21 and Comparative Examples 1 to 4]

As shown in Tables 3 and 4, a white pigment, a silane compound solution, and a liquid formulation were mixed in the ratio shown in Tables 3 and 4 to form each of samples 1 to 25.

Specifically, the white pigment (A) and the silane compound solution (B) prepared by the above process were mixed and dispersed by the method shown in Table 3 below. Subsequently, the liquid formulation (C) prepared by the above process was mixed with the liquid mixture of the white pigment (A) and the silane compound solution (B) and then mixed and dispersed by the method shown in Table 3.

**[Table 3]**

| | Sample | White pigment (A) | | Silane compound solution (B) | | Constituents of silane compound solution | | | | | | Liquid formulation (C) | | Mixing/dispersing method | | | |
|---|---|---|---|---|---|---|---|---|---|---|---|---|---|---|---|---|---|
| | | Compound name | Wt% | Silane compound solution No. | Wt% | Tetrafunctional wt% | Trifunctional wt% | Bifunctional wt% | Solvent wt% | Water wt% | Acid wt% | Liquid formulation No. | Wt% | A | B | C | Final |
| Example 1 | Sample 1 | CR-93 | 33 | Silane compound solution 2 | 58 | 7.4 | 2.6 | | 70 | 19.99 | 0.01 | Liquid formulation 1 | 9 | Ultrasound | | - | Stirrer |
| Example 2 | Sample 2 | HD-11 | 34 | Silane compound solution 2 | 50 | 7.4 | 2.6 | | 70 | 19.99 | 0.01 | Liquid formulation 2 | 16 | Ultrasound | | Ultrasound | Stirrer |
| Example 3 | Sample 3 | NFJ-3-1999 | 34 | Silane compound solution 2 | 50 | 7.4 | 2.6 | | 70 | 19.99 | 0.01 | Liquid formulation 3 | 16 | Ultrasound | | AWATORIRENTARO | Stirrer |
| Example 4 | Sample 4 | AP-100S | 34 | Silane compound solution 2 | 50 | 7.4 | 2.6 | | 70 | 19.99 | 0.01 | Liquid formulation 4 | 16 | Ultrasound | | Apex Mill | Stirrer |
| Example 5 | Sample 5 | CR-95 | 34 | Silane compound solution 2 | 50 | 7.4 | 2.6 | | 70 | 19.99 | 0.01 | Liquid formulation 5 | 16 | Ultrasound | | Stirrer | Stirrer |
| Example 6 | Sample 6 | CR-95 | 33 | Silane compound solution 2 | 50 | 7.4 | 2.6 | | 70 | 19.99 | 0.01 | Liquid formulation 6 | 17 | Stirrer | | HOMO MIXER | Stirrer |
| Example 7 | Sample 7 | CR-95 | 30 | Silane compound solution 2 | 50 | 7.4 | 2.6 | | 70 | 19.99 | 0.01 | Liquid formulation 7 | 20 | HOMO MIXER | | FILMIX | Stirrer |
| Example 8 | Sample 8 | CR-95 | 35 | Silane compound solution 2 | 50 | 7.4 | 2.6 | | 70 | 19.99 | 0.01 | Liquid formulation 8 | 15 | Apex Mill | | CLEAMIX | Stirrer |
| Example 9 | Sample 9 | CR-95 | 10 | Silane compound solution 2 | 56 | 7.4 | 2.6 | | 70 | 19.99 | 0.01 | Liquid formulation 9 | 34 | Stirrer | | Ultimizer | Stirrer |
| Example 10 | Sample 10 | CR-95 | 30 | Silane compound solution 2 | 50 | 7.4 | 2.6 | | 70 | 19.99 | 0.01 | Liquid formulation 10 | 20 | FILMIX | | Nanomizer | Stirrer |
| Example 11 | Sample 11 | CR-95 | 30 | Silane compound solution 2 | 50 | 7.4 | 2.6 | | 70 | 19.99 | 0.01 | Liquid formulation 11 | 20 | HOMO MIXER | | Stirrer | Stirrer |
| Example 12 | Sample 12 | CR-95 | 30 | Silane compound solution 2 | 50 | 7.4 | 2.6 | | 70 | 19.99 | 0.01 | Liquid formulation 12 | 20 | AWATORIRENTARO | | Stirrer | Stirrer |
| Example 13 | Sample 13 | CR-95 | 66 | Silane compound solution 2 | 20 | 7.4 | 2.6 | | 70 | 19.99 | 0.01 | Liquid formulation 6 | 14 | Ultimizer | | HOMO MIXER | Stirrer |
| Example 14 | Sample 14 | CR-95 | 10 | Silane compound solution 2 | 55 | 7.4 | 2.6 | | 70 | 19.99 | 0.01 | Liquid formulation 6 | 35 | Nanomizer | | HOMO MIXER | Stirrer |
| Comparative Example 1 | Sample 15 | CR-93 | 38 | Silane compound solution 1 | 55 | 7.6 | 2.4 | | 70 | 19.99 | 0.01 | Liquid formulation 6 | 7 | Ultrasound | | HOMO MIXER | Stirrer |
| Example 15 | Sample 16 | CR-93 | 45 | Silane compound solution 3 | 45 | | 20 | | 60 | 19.99 | 0.01 | Liquid formulation 6 | 10 | Ultrasound | | HOMO MIXER | Stirrer |
| Example 16 | Sample 17 | CR-93 | 45 | Silane compound solution 4 | 40 | | 16.4 | 3.6 | 60 | 19.99 | 0.01 | Liquid formulation 6 | 15 | Ultrasound | | HOMO MIXER | Stirrer |
| Comparative Example 2 | Sample 18 | CR-93 | 45 | Silane compound solution 5 | 35 | | 15.6 | 4.4 | 60 | 19.99 | 0.01 | Liquid formulation 6 | 20 | Ultrasound | | HOMO MIXER | Stirrer |
| Example 17 | Sample 19 | CR-93 | 32 | Silane compound solution 6 | 48 | 4.1 | 4.1 | 1.8 | 70 | 19.99 | 0.01 | Liquid formulation 6 | 20 | Ultrasound | | HOMO MIXER | Stirrer |
| Comparative Example 3 | Sample 20 | CR-93 | 32 | Silane compound solution 7 | 48 | 3.9 | 3.9 | 2.2 | 70 | 19.99 | 0.01 | Liquid formulation 6 | 20 | Ultrasound | | HOMO MIXER | Stirrer |
| Comparative Example 4 | Sample 21 | CR-93 | 32 | Silane compound solution 8 | 48 | 7 | 2 | 1 | 70 | 19.99 | 0.01 | Liquid formulation 6 | 20 | Ultrasound | | HOMO MIXER | Stirrer |
| Example 18 | Sample 22 | CR-93 | 20 | Silane compound solution 9 | 48 | 9.6 | 10.6 | | 70.4 | 9.39 | 0.01 | Liquid formulation 6 | 32 | Ultrasound | | HOMO MIXER | AWATORIRENTARO |
| Example 19 | Sample 23 | CR-93 | 33 | Silane compound solution 10 | 34 | | 15 | | 80 | 4.99 | 0.01 | Liquid formulation 6 | 33 | Stirrer | | HOMO MIXER | Stirrer |
| Example 20 | Sample 24 | CR-93 | 33 | Silane compound solution 10 | 34 | | 15 | | 80 | 4.99 | 0.01 | Liquid formulation 11 | 33 | Stirrer | | Stirrer | HOMO MIXER |
| Example 21 | Sample 25 | CR-93 | 33 | Silane compound solution 10 | 34 | | 15 | | 80 | 4.99 | 0.01 | Liquid formulation 12 | 33 | Stirrer | | Stirrer | Nanomizer |

**[Table 4]**

| | Sample | Contents (wt%) of components other than solvent in coating liquid | | | | | | Composition of coating liquid (wt%) | | | | | | | Evaluation results | | | | |
|---|---|---|---|---|---|---|---|---|---|---|---|---|---|---|---|---|---|---|---|
| | | White pigment | Silane compound | Inorganic particles | Metal oxide fine particles | Clay mineral particles | Silane coupling agent | Solid concentration of coating liquid | White pigment | Silane compound | Inorganic particles | Metal oxide fine particles | Clay mineral particles | Silane coupling agent | Viscosity (mPa·s) | Coating amount stability | Cracking during film formation | Reflectance (20 µm) | Tape test (peeling state) |
| Example 1 | Sample 1 | 85.1 | 14.9 | 0.0 | 0.0 | 0.0 | 0.0 | 38.8 | 33.0 | 5.8 | 0.0 | 0.0 | 0.0 | 0.0 | 5 | Δ | ○ | ○ | ○ |
| Example 2 | Sample 2 | 85.4 | 12.6 | 12.6 | 0.0 | 0.0 | 0.0 | 39.8 | 34.0 | 5.0 | 0.8 | 0.0 | 0.0 | 0.0 | 15 | ○ | ○ | ○ | ○ |
| Example 3 | Sample 3 | 85.1 | 12.5 | 7.5 | 7.5 | 0.0 | 0.0 | 40.0 | 34.0 | 5.0 | 0.5 | 0.5 | 0.0 | 0.0 | 20 | ○ | ○ | ○ | ⊙ |
| Example 4 | Sample 4 | 85.4 | 12.6 | 0.0 | 0.0 | 12.6 | 0.0 | 39.8 | 34.0 | 5.0 | 0.0 | 0.0 | 0.8 | 0.0 | 60 | ○ | ○ | ○ | ○ |
| Example 5 | Sample 5 | 86.5 | 12.7 | 0.0 | 0.0 | 5.1 | 0.0 | 39.3 | 34.0 | 5.0 | 0.0 | 0.0 | 0.3 | 0.0 | 120 | ○ | ○ | ○ | ○ |
| Example 6 | Sample 6 | 84.9 | 12.9 | 7.7 | 0.0 | 5.1 | 0.0 | 38.9 | 33.0 | 5.0 | 0.5 | 0.0 | 0.3 | 0.0 | 80 | ○ | ○ | ○ | ○ |
| Example 7 | Sample 7 | 82.4 | 13.7 | 13.7 | 0.0 | 5.5 | 0.0 | 36.4 | 30.0 | 5.0 | 1.0 | 0.0 | 0.4 | 0.0 | 520 | Δ | ○ | ○ | ○ |
| Example 8 | Sample 8 | 85.6 | 12.2 | 0.0 | 0.0 | 7.3 | 0.0 | 40.9 | 35.0 | 5.0 | 0.0 | 0.5 | 0.5 | 0.0 | 60 | ○ | ○ | ○ | ○ |
| Example 9 | Sample 9 | 64.1 | 35.9 | 0.0 | 0.0 | 0.0 | 6.4 | 15.6 | 10.0 | 5.6 | 0.0 | 0.0 | 0.0 | 0.3 | 5 | Δ | ○ | ○ | ⊙ |
| Example 10 | Sample 10 | 82.9 | 13.8 | 8.3 | 0.0 | 8.3 | 5.5 | 36.2 | 30.0 | 5.0 | 0.6 | 0.0 | 0.5 | 0.4 | 100 | ○ | ○ | ○ | ⊙ |
| Example 11 | Sample 11 | 82.9 | 13.8 | 8.3 | 0.0 | 8.3 | 5.5 | 36.2 | 30.0 | 5.0 | 0.6 | 0.0 | 0.5 | 0.4 | 80 | ○ | ○ | ○ | ⊙ |
| Example 12 | Sample 12 | 82.4 | 13.7 | 5.5 | 8.2 | 5.5 | 5.5 | 36.4 | 30.0 | 5.0 | 0.4 | 0.6 | 0.4 | 0.4 | 100 | ○ | ○ | ○ | ⊙ |
| Example 13 | Sample 13 | 96.1 | 2.9 | 4.4 | 0.0 | 2.9 | 0.0 | 68.7 | 66.0 | 2.0 | 0.4 | 0.0 | 0.3 | 0.0 | 120 | ○ | ○ | ○ | Δ |
| Example 14 | Sample 14 | 58.0 | 31.9 | 17.4 | 0.0 | 11.6 | 0.0 | 17.3 | 10.0 | 5.5 | 1.1 | 0.0 | 0.7 | 0.0 | 50 | ○ | ○ | Δ | ○ |
| Comparative Example 1 | Sample 15 | 86.7 | 12.5 | 6.8 | 0.0 | 4.6 | 0.0 | 43.9 | 38.0 | 5.5 | 0.2 | 0.0 | 0.1 | 0.0 | 100 | ○ | × | × | Unevaluated |
| Example 15 | Sample 16 | 82.6 | 16.5 | 5.5 | 0.0 | 3.7 | 0.0 | 54.5 | 45.0 | 9.0 | 0.3 | 0.0 | 0.2 | 0.0 | 90 | ○ | Δ | ○ | ○ |
| Example 16 | Sample 17 | 83.7 | 14.9 | 5.6 | 0.0 | 3.7 | 0.0 | 53.8 | 45.0 | 8.0 | 0.5 | 0.0 | 0.3 | 0.0 | 100 | ○ | ○ | ○ | ○ |
| Comparative Example 2 | Sample 18 | 84.9 | 13.2 | 5.7 | 0.0 | 3.8 | 0.0 | 53.0 | 45.0 | 7.0 | 0.6 | 0.0 | 0.4 | 0.0 | 110 | ○ | ○ | ○ | × |
| Example 17 | Sample 19 | 84.7 | 12.7 | 7.9 | 0.0 | 5.3 | 0.0 | 37.8 | 32.0 | 4.8 | 0.6 | 0.0 | 0.4 | 0.0 | 100 | ○ | ○ | ○ | ○ |
| Comparative Example 3 | Sample 20 | 84.7 | 12.7 | 7.9 | 0.0 | 5.3 | 0.0 | 37.8 | 32.0 | 4.8 | 0.6 | 0.0 | 0.4 | 0.0 | 120 | ○ | ○ | ○ | × |
| Comparative Example 4 | Sample 21 | 84.7 | 12.7 | 7.9 | 0.0 | 5.3 | 0.0 | 37.8 | 32.0 | 4.8 | 0.6 | 0.0 | 0.4 | 0.0 | 120 | ○ | × | × | Unevaluated |
| Example 18 | Sample 22 | 63.9 | 31.0 | 9.6 | 0.0 | 6.4 | 0.0 | 31.3 | 20.0 | 9.7 | 1.0 | 0.0 | 0.6 | 0.0 | 120 | ○ | ○ | ○ | ○ |
| Example 19 | Sample 23 | 83.0 | 12.8 | 7.5 | 0.0 | 5.0 | 0.0 | 39.8 | 33.0 | 5.1 | 1.0 | 0.0 | 0.7 | 0.0 | 100 | ○ | ○ | ○ | ○ |
| Example 20 | Sample 24 | 82.3 | 12.7 | 7.5 | 0.0 | 7.5 | 0.0 | 40.1 | 33.0 | 5.1 | 1.0 | 0.0 | 1.0 | 0.7 | 120 | ○ | ○ | ○ | ⊙ |
| Example 21 | Sample 25 | 81.7 | 12.6 | 4.9 | 7.4 | 4.9 | 4.9 | 40.4 | 33.0 | 5.1 | 0.7 | 1.0 | 0.7 | 0.7 | 90 | ○ | ○ | ○ | ⊙ |

### (Evaluation)

### <Viscosity evaluation>

The viscosity of the coating liquid was measured with a vibratory viscometer VISCOMATE MODEL VM-10A (manufactured by SEKONIC CORPORATION). The measurement temperature was 25°C. The value measured one minute after the immersion of the vibrator in the liquid was used.

### <Evaluation of coating amount stability>

The syringe of a dispenser was filled with the coating liquid. Under constant conditions, dispensing was performed consecutively 10 times, and then the total weight of the dispensed liquid was determined. Subsequently, while the syringe was maintained as it was, the same procedure was performed every 10 minutes. After 4 hours, under the same conditions, dispensing was performed consecutively 10 times, and then the total weight of the dispensed liquid was determined.

The weight change rate was calculated from the following formula: weight change rate = {(B - A)/A} x 100%, wherein A is the total weight of the coating liquid dispensed in the first 10 times, and B is the total weight of the coating liquid dispensed in the 10 times after 4 hours.

The coating amount stability was classified as follows.
○: The weight change rate was less than 3%.
Δ: The weight change rate was 3% or more.

### <Evaluation of film forming ability (cracking during film formation)>

The coating liquid was applied to a silver plate and then cured by heat treatment at 150°C for 1 hour to form a measurement sample having a 20-µm-thick reflective layer. In this process, the state of the reflective layer was visually observed and evaluated as follows.
○: No cracking was observed in the reflective layer.
Δ: Slight cracking occurred in the reflective layer, but no chipping of the reflective layer was observed.
×: Cracking occurred in the reflective layer, and part of the reflective layer chipped from the substrate.

### <Measurement of reflectance>

The coating liquid was applied to a 1 mm transparent glass plate and then cured by heat treatment at 150°C for 1 hour to form a measurement sample having a 20-µm-thick reflective layer. The reflectance of each sample was measured with a spectrophotometer V-670 (manufactured by JASCO Corporation). The results were evaluated as follows.
○: The reflectance at a wavelength of 500 nm was 95% or more.
Δ: The reflectance at a wavelength of 500 nm was from 90% to less than 95%.
×: The reflectance at a wavelength of 500 nm was less than 90%.

### <Tape peel test>

The coating liquid was applied to a silver plate and then cured by heat treatment at 150°C for 1 hour to form a measurement sample having a 20-µm-thick reflective layer. CELLOTAPE (registered trademark) (24 mm) manufactured by Nichiban Co., Ltd. was bonded to the formed reflective layer and then immediately peeled off. This procedure was repeated 20 times. The state of the reflective layer was observed with a microscope after every procedure and evaluated as follows.
⊙: Even after the procedure was performed 20 times, no peeling of the reflective layer was observed, and nothing adhered to the surface of the tape.
○: No peeling was observed after the procedure was performed 15 times, but peeling was slightly observed after the procedure was performed 20 times.
Δ: Although no peeling occurred, a powder of the white pigment slightly adhered to the surface of the tape after the first procedure was performed.
×: Peeling of the reflective layer occurred at the time when the procedure was performed 15 times.

Table 4 shows the evaluation results. The results in Table 4 have revealed the following.

It has been found that the adhesion to the substrate decreases as the content of the bifunctional silane compound increases above 20% by weight (Comparative Examples 2 and 3 using silane compound solutions 5 and 7, respectively).

A comparison between Comparative Examples 1 and 4 using silane compound solutions 1 and 8, respectively and Examples 1 to 21 using other silane compound solutions has shown that cracking occurs during film formation when the tetrafunctional silane compound/trifunctional silane compound ratio exceeds 3.

A comparison between Examples 1 and 9 and Examples 2 to 6, 8, and 10 to 21 has shown that as the viscosity of the coating liquid decreases, the coating amount stability decreases. This may be because of changes in concentration caused by settling of the white pigment.

A comparison between Example 7 and Examples 2 to 6 and 8 to 21 has shown that when the viscosity of the coating liquid becomes too high, the coating stability becomes low. This may be because the pressure loss in the dispenser gradually decreases so that the discharge amount increases.

A comparison between Examples 1 and 9 and Examples 2, 3, 6, 7, and 10 to 21 has shown that the addition of inorganic particles increases the viscosity to produce a settling-preventing effect and improve coating stability.

A comparison between Examples 3, 12, and 21 and Examples 1, 2, 4 to 8, and 13 to 20 has shown that the addition of metal oxide fine particles (particularly zirconium oxide particles or titanium oxide particles) produces an anchoring effect to increase the adhesion of the film and the peel strength.

A comparison between Examples 15 and 21 has shown that when the silane compound is polymerized in advance to form an oligomer, shrinkage can be suppressed during curing by heating, so that cracking becomes less likely to occur.

A comparison between Example 14 and Examples 1 to 12 and 15 to 21 has shown that the reflectance decreases as the content of the white pigment decreases.

A comparison between Example 13 and Examples 1 to 12 and 15 to 21 has shown that when the content of the white pigment becomes too high, the amount of the binder becomes insufficient so that a powder becomes more likely to appear on the surface.

A comparison between Examples 9 to 12, 20, and 21 and Examples 1, 2, 4 to 8, and 13 to 19 has shown that the addition of a coupling agent increases the adhesion to the substrate and improves sulfuration prevention performance and peel strength.

### Reference Signs List

1 substrate
2 LED element
11, 11C, 11D wavelength conversion layer
21, 21C, 21D reflective layer
100A, 100B, 100C, 100D LED device

## Claims

1. A coating liquid comprising a white pigment, a silane compound or compounds, and a solvent,
the coating liquid satisfying both of the following conditions: 0 ≤ R2 < 20 (formula 1) ; and 0 ≤ R4/R3 ≤ 3 (formula 2), wherein R2 is the content (% by mole) of a bifunctional silane compound in the total amount of the silane compound or compounds, R3 is the content (% by mole) of a trifunctional silane compound in the total amount of the silane compound or compounds, and R4 is the content (% by mole) of a tetrafunctional silane compound in the total amount of the silane compound or compounds.

2. The coating liquid according to claim 1, wherein at least one selected from the group consisting of the bifunctional silane compound, the trifunctional silane compound, and the tetrafunctional silane compound is already polymerized.

3. The coating liquid according to claim 1 or 2, further comprising, apart from the white pigment, at least one selected from the group consisting of metal oxide fine particles with an average particle size of 5 nm to less than 100 nm, inorganic particles with an average particle size of 100 nm to 100 µm, and clay mineral particles.

4. The coating liquid according to claim 3, wherein the clay mineral particles are made of at least one selected from the group consisting of a layered silicate mineral, imogolite, and allophane.

5. The coating liquid according to any one of claims 1 to 4, further comprising a silane coupling agent.

6. The coating liquid according to any one of claims 1 to 5, wherein the solvent comprises at least one of a monohydric alcohol and a dihydric or polyhydric alcohol.

7. The coating liquid according to any one of claims 1 to 6, wherein the white pigment is at least one selected from the group consisting of titanium oxide, aluminum oxide, barium sulfate, zinc oxide, and boron nitride.

8. The coating liquid according to any one of claims 1 to 7, which has a viscosity of more than 5 mPa·s to 500 mPa·s.

9. The coating liquid according to any one of claims 1 to 8, which contains the white pigment in such a concentration that a solid obtained by heating and curing the coating liquid contains 60% by weight to 95% by weight of the white pigment.

10. An LED device comprising:
a substrate;
an LED element disposed on the substrate;
a reflective layer disposed at least around the LED element on the substrate; and
a wavelength conversion layer disposed over the LED element and the reflective layer, wherein
the reflective layer is a product obtained by heating and curing a coating liquid that comprises a white pigment, a silane compound or compounds, and a solvent and satisfies both of the following conditions: 0 ≤ R2 < 20 (formula 1); and 0 ≤ R4/R3 ≤ 3 (formula 2), wherein R2 is the content (% by mole) of a bifunctional silane compound in the total amount of the silane compound or compounds, R3 is the content (% by mole) of a trifunctional silane compound in the total amount of the silane compound or compounds, and R4 is the content (% by mole) of a tetrafunctional silane compound in the total amount of the silane compound or compounds.

11. The LED device according to claim 10, wherein the reflective layer is disposed on an area of the substrate, other than an area where the LED element is disposed.

12. The LED device according to claim 10, wherein the reflective layer is formed between the substrate and the LED element.
